# EUROPÄISCHE PATENTSCHRIFT

(11) **EP 2 004 936 B1**
(45) Veröffentlichungstag und Bekanntmachung des Hinweises auf die Patenterteilung: **22.02.2017**
(21) Anmeldenummer: 07722161.2
(22) Anmeldetag: 03.04.2007
(51) Int. Cl.: E05B 17/22, H05K 1/18

(54) **VORRICHTUNG FÜR EIN KRAFTFAHRZEUGSCHLOSS MIT KOMPONENTENTRÄGER**
DEVICE FOR A MOTOR VEHICLE LOCK WITH COMPONENT MOUNTING
DISPOSITIF POUR SERRURE DE VÉHICULE À MOTEUR COMPRENANT DES SUPPORTS DE COMPOSANTS

(30) Priorität: 13.04.2006 DE 102006017830
(43) Veröffentlichungstag der Anmeldung: 24.12.2008
(73) Patentinhaber: Kiekert Aktiengesellschaft, 42579 Heiligenhaus (DE)
(72) Erfinder: WILMS, Dirk, 47259 Duisburg (DE); MAUEL, Heinz-Dieter, 53909 Zülpich (DE); KUNST, Frank, 59348 Lüdinghausen (DE)
(86) Internationale Anmeldenummer: PCT/DE2007/000603
(87) Internationale Veröffentlichungsnummer: WO 2007/118451

(56) Entgegenhaltungen:
- EP-A- 1 231 824
- DE-B3- 10 320 441
- DE-U1-202005 015 588

## Beschreibung

Die vorliegende Erfindung betrifft eine Vorrichtung für ein Kraftfahrzeugschloss mit einem Elektrokomponententräger zum Einlegen in ein Gehäuse, insbesondere in ein Kraftfahrzeugtürschloss-Gehäuse.

Ein üblicher Aufbau eines solchen Komponententrägers geht beispielsweise aus der EP 1 231 824 A2 hervor. Dort wird eine Leiterbahneinheit beschrieben, die mit Bauteilen bestückt werden kann. Beispiele für solche Bauteile sind Stecker, Mikroschalter, Sensoren, Motoren, usw., die in einer Türschlosseinheit eines Kraftfahrzeugs zum Einsatz kommen. Die Leiterbahneinheit besteht dabei im Wesentlichen aus einer flexiblen Leiterbahnfolie, welche von zwei Versteifungselementen zu einem Modul aus Kunststoff umspritzt ist. Für die Anbringung der angeführten Bauteile kann das Modul noch mit einer gesonderten Aufnahme im Rahmen des Umspritzens versehen werden. Mit einer solchen Leiterbahneinheit wurde es bei Kraftfahrzeugtürschlössern möglich, einen relativ steifen bzw. formstabilen Komponententräger bereitzustellen, mit dem eine sichere Positionierung der Bauteile bezüglich des Kraftfahrzeugschlosses gewährleistet werden kann.

Im Hinblick auf die vielfach unterschiedliche Ausgestaltung solcher Kraftfahrzeugtürschlösser, insbesondere mit Bezug auf die unterschiedlichen Ausführungsvarianten als elektrisch öffnendes Schloss, Türschloss mit Zentralverriegelung, Türschloss mit Personenidentifikationseinheit, Türschlösser mit Kinder- und/oder Diebstahlsicherung, Schlösser mit Zuziehhilfe und dergleichen, sind diese Komponententräger regelmäßig mit unterschiedlichen Bauteilen zu bestücken und entsprechende elektrische Verbindungen bereitzustellen. Auch wenn es sich bei dem bekannten Komponententräger um ein relativ kostengünstig herstellbares Bauteil handelt, so ist doch bei der angedeuteten Variantenvielfalt beachtlicher Aufwand bezüglich der Logistik und der Lagerung erforderlich.

Hiervon ausgehend ist es Aufgabe der vorliegenden Erfindung, die mit Bezug auf den Stand der Technik geschilderten Probleme zumindest teilweise zu lösen. Insbesondere soll eine Vorrichtung für ein Kraftfahrzeugschloss angegeben werden, die flexibel einsetzbar und gegebenenfalls auch erweiterbar ist. Dabei sollen gleichzeitig die mit der Herstellung einer solchen Vorrichtung verbundenen Kosten reduziert und der logistische Aufwand gemindert werden.

Diese Aufgaben werden gelöst mit einer Vorrichtung gemäß den Merkmalen des Patentanspruchs 1. Weitere vorteilhafte Ausgestaltungen der Vorrichtung sind in den abhängig formulierten Patentansprüchen angegeben. Es ist darauf hinzuweisen, dass die in den Patentansprüchen einzeln aufgeführten Merkmale in beliebiger, technologisch sinnvoller, Weise miteinander kombiniert werden können und weitere Ausgestaltungen der Erfindung aufzeigen. Darüber hinaus werden die in den Patentansprüchen angegebenen technischen Merkmale in der Beschreibung näher präzisiert und erläutert, wobei weitere bevorzugte Ausführungsvarianten der Erfindung dargestellt werden.

Die erfindungsgemäße Vorrichtung für ein Kraftfahrzeugschloss umfasst wenigstens einen ersten Komponententräger und einen zweiten Komponententräger, wobei die Komponententräger jeweils zumindest eine Komponente aus der Gruppe elektrisches Bauteil, elektromechanisches Bauteil und elektronisches Bauteil bezüglich des Kraftfahrzeugsschlosses fixieren und miteinander verbunden oder verbindbar sind.

Die Vorrichtung findet insbesondere Anwendung im Rahmen eines Kraftfahrzeugsschlosses für Türen, Klappen und dergleichen. Zumindest einer der Kompo nententräger ist bevorzugt nach Art der eingangs geschilderten Leiterbahneinheiten aufgebaut, wobei gegebenenfalls die Leiterbahnfolie als eine Art Stanzgitter ausgebildet sein kann. Unter einem "elektrischen Bauteil" werden Bauteile verstanden, die beispielsweise die Stellung von im Kraftfahrzeugtürschloss befindlichen Hebeln, wie z. B. den Zentralverriegelungshebel, Drehfalle und/oder Sperrklinke berührungslos abfragen. Beispiele für solche "elektrische Bauteile" sind Hall-Sensoren, Reed-Kontakte und dergleichen. Dem gegenüber sollen unter "elektromechanischen Bauteilen" solche verstanden werden, die über einen mechanischen Kontakt mit den vorstehend genannten Elementen (Hebel, Drehfalle, Sperrklinke) interagieren (z.B. Mikroschalter, Reibkontakte, Elektromotoren und dergleichen). "Elektronische Bauteile" sind in der Regel Steuergeräte, die zumeist einen Mikroprozessor aufweisen und/oder die eine Auswertung der von den elektrischen oder elektromechanischen Bauteilen abgegebenen Signale vornehmen und/oder die Energieversorgung dafür regeln. Diese Bauteile sind mit ersten und/oder dem zweiten Komponententräger verbunden, wobei sie bevorzugt dauerhaft in der gewünschten Orientierung, Lage beziehungsweise Position gehalten werden können.

Die hier vorgeschlagene Vorrichtung ist folglich modular aufgebaut, und umfasst mindestens zwei solcher Komponententräger. Auch wenn nachfolgend die Ausführungsvariante mit nur zwei Komponententrägern beschrieben wird, können gleichwohl mehrerer Komponententräger (beispielsweise drei oder vier) vorgesehen sein. Dies eröffnet die Möglichkeit, bei der Herstellung solcher Vorrichtungen aufbauend auf einem Basis-Komponententräger zusätzliche Module aus Komponententrägern an dem Basis-Komponententräger zu applizieren und so einerseits die elektrischen, elektromechanischen und/oder elektronischen Bauteile zueinander bzw. im Hinblick auf die Gestaltung des Kraftfahrzeugschlosses angepasst auszurichten und positionieren.

Die Verbindung der Komponententräger erfolgt dabei bevorzugt direkt, dass heißt insbesondere ohne zusätzlich Anschlussteile. Hierfür liegt regelmäßig ein direkter Kontakt des ersten Komponententrägers mit dem zweiten Komponententräger vor. Dabei werden formschlüssige und/oder kraftschlüssige Verbindungen miteinander bevorzugt. Bei besonderen Anwendungsfällen kann es unter Umständen noch erforderlich sein, diese direkte Verbindung mit einer Klebverbindung zu unterstützen. Diese Vorrichtung mit den mindestens zwei Komponententrägern kann demnach einerseits als Bausatz bereitgestellt werden, dann sind die Komponententräger so ausgebildet, dass Adapterstellen für den Anschluss weiterer Komponententräger bereitgestellt sind, so dass sie miteinander verbindbar sind. Es ist jedoch auch möglich, dass diese Komponententräger bereits miteinander verbunden und gegebenenfalls schon in einem Kraftfahrzeugschloss eingebaut sind.

Mit der Bereitstellung einer solchen modularen Bauweise hinsichtlich der Komponententräger können die Variantenvielfalt hinsichtlich solcher Teile gerade in der Serienfertigung und damit auch der technische Aufwand und die Herstellungskosten deutlich reduziert werden.

Gemäß einer bevorzugten Ausgestaltung der Vorrichtung ist die projizierte Grundfläche des ersten Komponententrägers mit dem zweiten Komponententräger vergrößert. Dabei wird insbesondere von der Vorstellung ausgegangen, dass ein solcher Komponententräger eine primäre Ausdehnungsebene hat, in der er seine größte Ausdehnung aufweist. Bei einer Projektion des einen Komponententrägers in eine parallele Ebene zu der primären Ausdehnungsebene entsteht die projizierte Grundfläche. Der zweite Komponententräger bzw. jeder weitere Komponententräger wird nun in vorteilhafter Weise so gestaltet, dass er bei einer Verbindung mit dem ersten Komponententräger die projizierte Grundfläche des Gesamt-Komponententrägers vergrößert. Damit ist insbesondere zum Ausdruck gebracht, dass die weiteren Komponententräger ebenfalls eine Ausdehnung von beachtli chem Ausmaß in einer (parallelen) Ausdehnungsebene haben, wobei sich die jeweils projizierten Grundflächen nur bevorzugt nur unwesentlich überlagern bzw. überdecken. Insbesondere wird durch das Anfügen mindestens eines weiteren Komponententrägers an den ersten Komponententräger die projezierte Grundfläche um mindestens 20 % vergrößert, bevorzugt in einem Bereich von 20% bis 100%. Diese Ausgestaltung der Vorrichtung hat zur Folge, dass die Fläche der Komponententräger in einer primäre Ausdehnungsebene deutlich erweitert wird, so dass weitere Bauteile angefügt werden und in einem relativ schlanken Kraftfahrzeugschloss untergebracht werden können.

Des Weiteren wird auch vorgeschlagen, dass zumindest der erste Komponententräger oder der zwei Komponententräger flächig ausgebildet ist und nur mit einem Teil seines Umfangs mit dem anderen Komponententräger verbunden ist. Mit "Umfang" ist dabei die äußere Begrenzung des flächigen Komponententrägers gemeint (auch Kannte genannt). Ganz besonders bevorzugt liegt der Teil des Umfangs bei weniger als 50%, insbesondere bei weniger als 30% des Umfangs des Komponententrägers, der die größten Abmessungen aufweist. Wird der Teil des Umfangs deutlich kleiner gewählt, beispielsweise kleiner 10% sind zusätzliche Halteelemente gegebenenfalls erforderlich und/oder eine sehr instabile Verbindung ist gegeben. Wird der hier angegebene Teil eines Umfangs deutlich überschritten, also beispielsweise beinahe der gesamte Umfang als Verbindungsbereich genutzt, treten Platzprobleme bei der Applizierung weiterer elektrischer, elektromechanischer und/oder elektronischer Bauteile auf.

Einer Weiterbildung der Vorrichtung zur Folge bilden der erste Komponententräger und der zweite Komponententräger eine gemeinsame Anlagefläche, wobei sie sich dort teilweise durchdringen. Damit sind insbesondere formschlüssige Verbindungen angegeben. Beispiele für solche Verbindung sind Klick- und/oder Clip-Verbindungen, Nut-Verbindungen, ineinander eingreifende Hinterschneidungen, Eingriffe und dergleichen, wobei dann regelmäßig zumindest ein Teilbereich eines der Komponententrägern von mehreren Seiten mit dem anderen Komponententräger in Kontakt ist. Ganz besonders bevorzugt ist die Ausgestaltung, bei der ein Komponententräger wenigstens eine Öffnung aufweist, durch die ein Stift, Zapfen oder dergleichen des anderen Komponententrägers hindurch geführt ist bzw. werden kann.

Vorteilhafter Weise bilden der ersten Komponententräger und der zweite Komponententräger eine zusammenhängende Aussparung zur Positionierung von Leiterbahnen. Unter einer "Aussparung" ist z. B. eine Art Nut, Wanne, Vertiefung, Rille, Fach oder dergleichen zu verstehen, in die die Leiterbahnen zumindest teilweise hinein appliziert werden können bzw. sind. Die (mindestens eine) Aussparung ist dabei so gestaltet, dass sie ausgehend von dem einen Komponententräger in den zweiten Komponententräger übergeht. Dies eröffnet die Möglichkeit, in die Aussparung später einen Füllstoff zu applizieren, der beispielsweise die Leiterbahnen vor Korrosion schützt.

Gemäß noch einer weiteren Ausgestaltung sind der erste Komponententräger und der zweite Komponententräger mit Kunststoff gefertigt. Dabei liegt insbesondere der Fall vor, dass zumindest einer der Komponententräger mit einem thermoplastischen Kunststoff aufgebaut sind, wie insbesondere Polybutylenterephthalat (PBT) oder Polypropylen (PP), wobei auch andere Thermoplaste wie z.B. ABS, in Frage kommen. Ferner ist es auch möglich, duroplastische Kunststoffmaterialen zu verwenden. Besonders bevorzugt kommt Polyamid (PA 6.6 mit einem Glasfaseranteil von ca. 30%) zum Einsatz. In besonderen Fällen können sogar die Leiterbahnen mit einem elektrisch leitenden Kunststoff gebildet sein.

Die Vorrichtung kann zudem in der Art weitergebildet werden, dass der erste Komponententräger und der zweite Komponententräger selbsttragend ausgeführt sind. Das bedeutet mit anderen Worten zum Beispiel, dass auch ein Verbund der Komponententräger in der Lage ist, die zu fixierenden Bauteile aufzunehmen, wobei der gewünschten Einbauposition bezüglich des Kraftfahrzeugschlosses nur eine unbeachtliche Verformung der Komponententräger auftrifft. Die Formgenauigkeit in dieser gewünschten Einbauposition ist bevorzugt so zu wählen, dass die Position des Mittelpunkts der getragenen Bauteile höchstens um 5 mm, insbesondere sogar um maximal 1 mm, abweicht gegenüber einer Ausgestaltung der Komponententräger, die absolut formsteif ist. Dies führt zu einer besonders robusten Ausführungsvariante des Kraftfahrzeugschlosses, da nunmehr lediglich Anbindungspunkte hin zu dem Kraftfahrzeugschloss gewählt werden müssen, die keine beachtlichen Kräfte aufnehmen müssen.

Schließlich wird auch noch vorgeschlagen, dass nur ein Komponententräger Anschlussmittel an eine Steuereinheit für alle Komponenten der Komponententräger aufweist. Das bedeutet mit anderen Worten, dass eine Art Basis-Komponententräger (hier als erster Komponententräger bezeichnet) vorliegt, der durch entsprechende Zusatzmodule ergänzt werden kann. Die entsprechenden Anschlüsse für gegebenenfalls einzusetzende Leiterbahnen (z.B. für Strom, Signalleitung, etc.) sind dabei Bestandteil des ersten Komponententrägers, wobei diese Leiterbahnen mit entsprechenden Leiterbahnen der weiteren Komponententräger kontaktiert werden können. Damit wird eine Steuerung bzw. Regelung der Bauteile jeder weiterer Komponententräger durch dieses einzelne Anschlussmittel gewährleistet. Die Anschlussmittel sind insbesondere nach Art eines Steckers ausgebildet.

Besondere Anwendung findet die erfindungsgemäß beschriebene Vorrichtung in einem Kraftfahrzeug. Dabei sind insbesondere Kraftfahrzeuge bevorzugt, die unterschiedlicher Ausgestaltungen der Vorrichtung aufweisen, beispielsweise im Hinblick auf Vordertüren, Hintertüren, Schiebetüren, Heckklappen oder dergleichen. Damit lassen sich beispielsweise bei diesen diversen Türen unterschiedliche Funktionen verwirklichen. Zur Veranschaulichung des Funktionsumfangs solcher Kraftfahrzeugschlösser kann folgendes ausgeführt werden:
In der Regel umfasst ein einfaches Kraftfahrzeugtürschloss eine Zentralverriegelungseinheit, welche das Kraftfahrzeugtürschloss zwischen einem "verriegelten" und einem "entriegelten" Zustand eletromotorisch schalten kann, oder umgekehrt. Dies kann beispielsweise auch durch das Betätigen einer Fernbedieneinheit erfolgen. Der Zustand "entriegelt" zeichnet sich dadurch aus, dass eine Betätigungskette zwischen einen Türinnengriff und dem Kraftfahrzeugtürschloss sowie einem Türaußengriff und dem Kraftfahrzeugtürschloss zum Öffnen der Kraftfahrzeugtür zumeist mechanisch gegeben ist. Der Zustand "verriegelt" dagegen beschreibt den Zustand, dass die Betätigungskette vom Türaußengriff zum Kraftfahrzeugtürschloss hin unterbrochen oder blockiert ist. Da hierzu bereits unterschiedliche elektrische, elektromechanische und gegebenenfalls elektronische Bauteile im Kraftfahrzeugtürschloss erforderlich sind, können diese Basis-Bauteile an einem entsprechenden Basis-Komponententräger positioniert sein.

Darüber hinaus kann das Kraftfahrzeugtürschloss aber auch noch mit weiteren Funktionen ausgestattet sein, wie z.B. die Funktion "Kinder-gesichert", bei der nur der Türinnengriff keine gängige Betätigungskette besitzt, und/oder " Dieb-stahl-gesichert" bei der weder Türinnen- noch Türaußengriff eine gängige Betätigungskette zum Kraftfahrzeugtürschloss besitzen. Die zusätzlichen Funktionen können ebenfalls eletromotorisch unterstützt geschaltet werden, so dass diese beispielsweise an einen zweiten Komponententräger positioniert werden können, der zur Realisierung dieses komplexeren Türschlosses mit dem Basis-Komponententräger verbunden werden kann.

Des Weiteren ist auch noch darauf hinzuweisen, dass das Kraftfahrzeugtürschloss neben diesen, den (Schließ-) Zustand des Kraftfahrzeugtürschlosses einstellbaren, Funktionen, mit einer Öffnungshilfe zum elektromotorischen Abheben einer Sperrklinke und/oder mit einer Schließhilfe zum elektromotorischen Antrieb einer Drehfalle von einer Vorrast- in eine Hauptrastlage versehen sein kann. Hierfür sind regelmäßig weitere Bauteile wie Hall-Sensoren oder Mikroschalter erforderlich, die die Hebelstellungen im Kraftfahrzeugtürschloss abfragen und diese Informationen an eine übergeordnete Steuereinheit weiterleiten, damit sie den alctuellen Zustand des Kraftfahrzeugtürschlosses bewerten kann. Für die Bereitstellung eines solchen komplexen Türschlosses kann folglich ein anderer und/oder ein weiterer Komponententräger mit dem Basis-Komponententräger verbinden sein.

Ergänzend sei noch angemerkt, dass die hier beschriebenen Komponententräger regelmäßig als eine Art Einlegeteil für einen besonderen Abschnitt des Kraftfahrzeugtürschlosses ausgebildet sind, insbesondere für einen Abschnitt des Kraftfahrzeugtürschloss-Gehäuses.

Die Erfindung sowie das technische Umfeld werden nachfolgend anhand der Figuren näher erläutert. Es ist darauf hinzuweisen, dass die in den Figuren veranschaulichten Vorrichtungen besonders bevorzugte Ausgestaltungen der Erfindung zeigen, diese jedoch nicht darauf begrenzt ist. Es zeigen schematisch:
- Fig. 1: eine erste Ausführungsvariante der erfindungsgemäßen Vorrichtung,
- Fig. 2: eine weitere Ausführungsvariante der erfindungsgemäßen Vorrichtung,
- Fig. 3: eine zusätzliche Ausführungsvariante eines modular aufgebauten Komponententrägers,
- Fig. 4: noch eine weitere Ausführungsvariante eines modular aufgebauten Komponententrägers, und
- Fig. 5: ein Kraftfahrzeug mit mehreren Ausführungsvarianten der Vorrichtung.

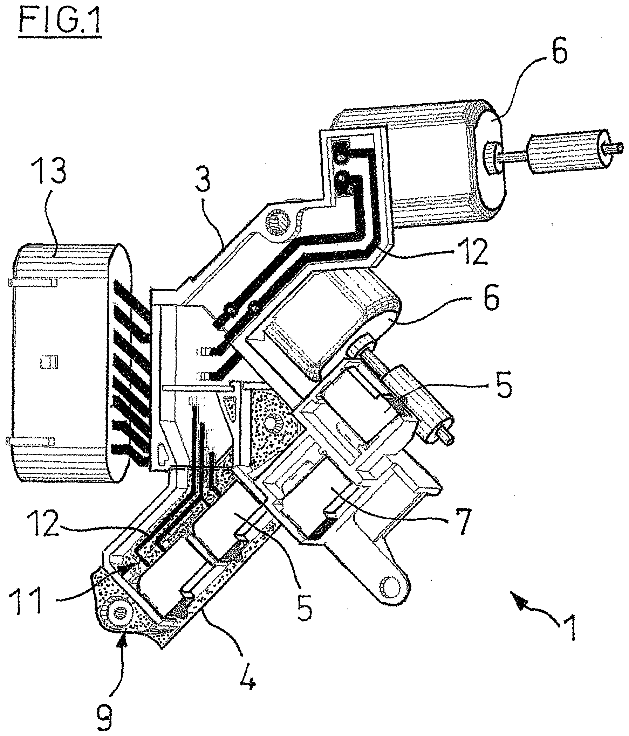

Fig. 1 veranschaulicht schematisch und in einer perspektivischen Ansicht eine erfindungsgemäße Vorrichtung 1 für ein Kraftfahrzeugschloss. Links in Fig. 1 dargestellt sind Anschlussmittel 13 nach Art eines Steckers, von dem ausgehend diverse Leiterbahnen 12 hin zu einem ersten Komponententräger 3 verlaufen. Der erste Komponententräger 3 ist hier nach Art eines Basis-Komponententrägers ausgeführt, der bereits eine Vielzahl von Bauteilen trägt. Der erste Komponententräger 3 ist aus Kunststoff gefertigt und bietet Anschlüsse und Halterungen für elektromechanische Bauteile 6 (hier dargestellt in Art eines Elektromotors) und ein elektrisches Bauteil 5 (hier als Mikroschalter ausgebildet). Darüber hinaus ist an dem ersten Komponententräger 3 auch ein elektronisches Bauteil 7 (hier ein Mikroprozessor) vorgesehen.

Im unteren linken Bereich von Fig. 1 ist zudem ein zweiter Komponententräger 4 gezeigt, wobei dessen Grundfläche zur Unterscheidung hier gepunktet dargestellt ist. Dieser zweite Komponententräger 4 weist ebenfalls zwei elektrische Bauteile 5 nach Art eines Mikroschalters auf. Diese elektrischen Bauteile 5 des zweiten Komponententrägers 4 sind mit Leiterbahnen 12 kontaktiert, die mit den Leiterbahnen 12 des ersten Komponententrägers 3 verbunden sind, beispielsweise verschweißt oder mit einer kraftschlüssigen Verbindung. Diese Leiterbahnen 12 sind in einer Aussparung 11 positioniert, die sich von dem zweiten Komponententräger 4 hin zum ersten Komponententräger 3 erschreckt, so dass die Aussparung 11 anschließend noch zum Schutz der Leiterbahnen 12 vor Feuchtigkeit mit einer Vergussmasse versiegelt werden kann. Entsprechende Aussparungen 11 lassen sich auch am ersten Komponententräger 3 erkennen.

Der zweite Komponententräger 4 ist bei der veranschaulichten Ausführungsvariante ebenso wie der erste Komponententräger 3 im Wesentlichen flächig ausgebildet und nur mit einem Teil seines Umfangs 9 mit dem ersten Komponententräger 3 in Kontakt. Mittig ist auch hier eine Anlagefläche zu erkennen, in der noch eine zusätzliche Arretierung vorgenommen ist. Auch wenn der hier veranschaulichte erste Komponententräger 3 nur eine Adaptionsstelle für einen (einzelnen) Komponententräger aufweist, so können gleichwohl mehrere davon vorgesehen sein, um weitere elektrische, elektromechanische oder elektronische Bauteile zu fixieren.

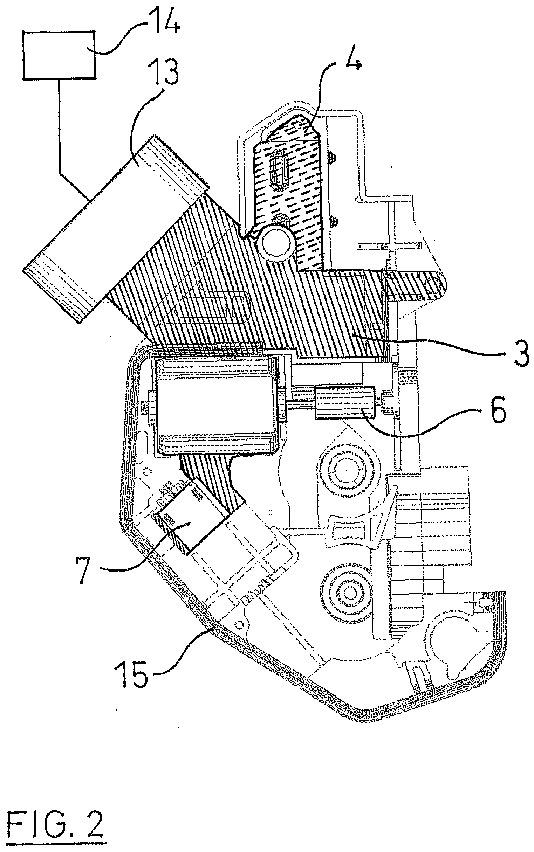

Fig. 2 zeigt eine vereinfachte Darstellung einer Ausführungsvariante der Vorrichtung, die bereits in einem Gehäuse 15 eines Kraftfahrzeugtürschlosses angeordnet ist. Zu erkennen ist wiederum das nach Art eines Steckers ausgebildete Anschlussmittel 13, dass mit einer Steuereinheit 14 verbunden ist. Mit unterschiedlichen Schraffuren sind gleichfalls der erste Komponententräger 3 und der daran befestigte, modulartig ausgestaltete, zweite Komponententräger 4 dargestellt. Selbstverständlich kann auch der zweite Komponententräger 4 Adapterstellen für weitere Komponententräger aufweisen, so dass dieser dann eine Verbindung von dem ersten hin zu einem dritten Komponententräger darstellt. Bei der Darstellung in Fig. 2 sind ein elektronisches Bauteil 7 und ein elektromechanisches Bauteil 6 zu erkennen, die an dem ersten Komponententräger 3 befestigt ist. Die Bauteile des zweiten Komponententrägers sind auf der rückwärtigen, hier nicht dargestellten Seite angeordnet.

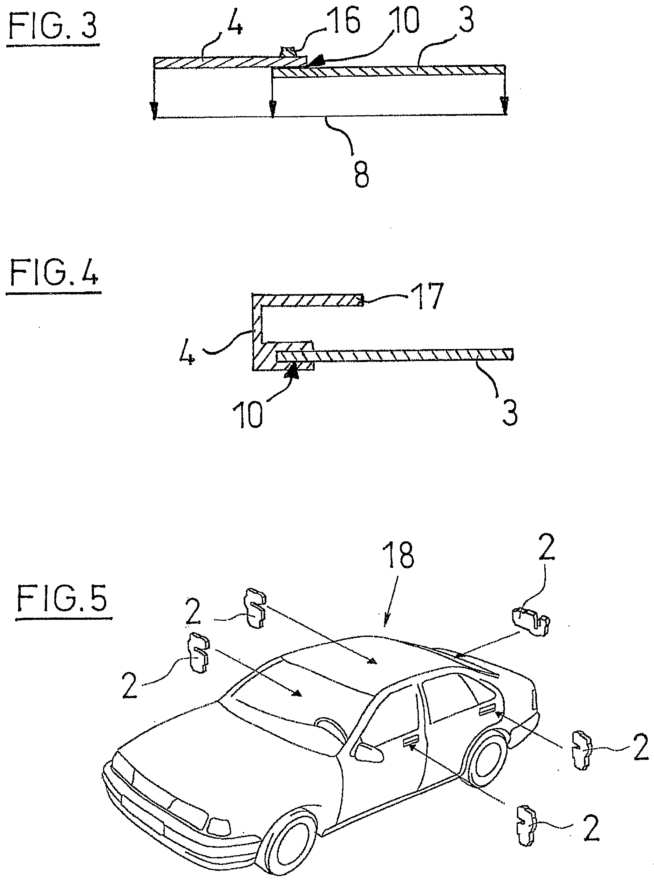

Fig. 3 veranschaulicht weiter schematisch eine mögliche, besonders bevorzugte, Ausführungsvariante für die Verbindung eines ersten Komponententrägers 3 mit einem zweiten Komponententräger 4. Dazu bilden der erste Komponententräger 3 und der zweite Komponententräger 4 eine gemeinsame Anlagefläche 10, indem sie sich teilweise überlagern, wobei sie in dieser gemeinsamen Anlagefläche 10 sich teilweise durchdringen. Dies ist hier dadurch realisiert, dass ein Zapfen 16 des ersten Komponententrägers 3 durch eine entsprechende Öffnung des zweiten Komponententrägers 4 hindurchragt und damit einen Formschluss bildet.

Veranschaulicht ist gleichzeitig schematisch, dass diese Module von Komponententrägern zusammen eine projizierte Grundfläche 8 bilden. Bei der in Fig. 3 gezeigten Ausführungsvariante sind beide Komponententräger im Wesentlichen flächig bzw. in einer Ebene angeordnet, wobei die projizierte Grundfläche 8 deutlich vergrößert wird. Ein anderes Beispiel für eine mögliche Anordnung der beiden Komponententräger zeigt Fig. 4. Dabei ist wiederum eine Anlagefläche 10 (hier nach Art einer Nut) gebildet, wobei der zweite Komponententräger 4 so gestaltet ist, dass der flächenmäßig größere Abschnitt 17 im Wesentlichen parallel zum ersten Komponententräger 3 angeordnet ist und diesen (beabstandet) überdeckt. Im Gegenteil zu der Darstellung in Fig. 3 wird mit einer Ausführungsvariante nach Fig. 4 die projizierte Grundfläche nicht wesentlich vergrößert. Gleichwohl kann auch mit der dargestellten Variante aus Fig. 4 neuer Platz für die Positionierung weiterer elektrischer, elektromotorischer oder elektronischer Bauteile geschaffen werden.

Fig. 5 veranschaulicht schließlich noch, dass die hier vorgeschlagene Kraftfahrzeugschlösser 2 an diversen Stellen eines Kraftfahrzeuges 18 eingesetzt werden können. Dabei ist es insbesondere möglich, die Kraftfahrzeugschlösser 2 mit geringem logistischem Aufwand jeweils an die entsprechenden Funktionen des Kraftfahrzeugschlosses auszubilden und am Kraftfahrzeug 18 anzuordnen.

### Bezugszeichenliste

- 1: Vorrichtung
- 2: Kraftfahrzeugschloss
- 3: erste Komponententräger
- 4: zweite Komponententräger
- 5: elektrisches Bauteil
- 6: elektromechanisches Bauteil
- 7: elektronisches Bauteil
- 8: projizierte Grundfläche
- 9: Umfang
- 10: Anlagefläche
- 11: Aussparung
- 12: Leiterbahn
- 13: Anschlussmittel
- 14: Steuereinheit
- 15: Gehäuse
- 16: Zapfen
- 17: Abschnitt
- 18: Kraftfahrzeug

## Patentansprüche

1. Vorrichtung (1) für ein Kraftfahrzeugschloss (2) umfassend wenigstens einen ersten Komponententräger (3) und einen zweiten Komponententräger (4), wobei die Komponententräger jeweils zumindest eine Komponente aus der Gruppe elektrisches Bauteil (5), elektromechanisches Bauteil (6) und elektronisches Bauteil (7) bezüglich des Kraftfahrzeugschlosses (2) fixieren und miteinander verbunden oder verbindbar sind.

2. Vorrichtung (1) nach Patentanspruch 1, bei der die projizierte Grundfläche (8) des ersten Komponententrägers (3) mit dem zweiten Komponententräger (4) vergrößert ist.

3. Vorrichtung (1) nach Patentanspruch 1 oder 2, bei der zumindest der erste Komponententrägers (3) oder der zweite Komponententräger (4) flächig ausgebildet ist und nur mit einem Teil seines Umfangs (9) mit dem anderen Komponententräger verbunden ist.

4. Vorrichtung (1) nach einem der vorhergehenden Patentansprüche, bei der der erste Komponententräger (3) und der zweite Komponententräger (4) eine gemeinsame Anlagefläche (10) bilden, wobei sie sich dort teilweise durchdringen.

5. Vorrichtung (1) nach einem der vorhergehenden Patentansprüche, bei der der erste Komponententräger (3) und der zweite Komponententräger (4) eine zusammenhängende Aussparung (11) zur Positionierung von Leiterbahnen (12) bilden.

6. Vorrichtung (1) nach einem der vorhergehenden Patentansprüche, bei der der erste Komponententräger (3) und der zweite Komponententräger (4) mit Kunststoff gefertigt sind.

7. Vorrichtung (1) nach einem der vorhergehenden Patentansprüche, bei der der erste Komponententräger (3) und der zweite Komponententräger (4) selbsttragend ausgeführt sind.

8. Vorrichtung (1) nach einem der vorhergehenden Patentansprüche, bei der nur ein Komponententräger Anschlussmittel (13) an eine Steuereinheit (14) für alle Komponenten der Komponententräger aufweist.

9. Kraftfahrzeug (18) aufweisend zumindest eine Vorrichtung (1) nach einem der vorhergehenden Patentansprüche.

## Claims

1. Device (1) for a motor vehicle door latch (2) comprising at least a first component carrier (3) and a second component carrier (4), whereby the component carriers in each instance fix at least one component from the electrical component (5), electromechanical component (6) and electronic component (7) group with regard to the motor vehicle latch (2) and are connected or can be connected to one another.

2. Device (1) according to patent claim 1, in which the projected surface area (8) of the first component carrier (3) is increased with the second component carrier (4).

3. Device (1) according to patent claim 1 or 2, in which at least the first component carrier (3) or the second component carrier (4) is two-dimensional and is only connected to the other component carrier with part of its circumference (9).

4. Device (1) according to one of the previous patent claims, in which the first component carrier (3) and the second component carrier (4) form a common contact surface (10), whereby they partially penetrate one another there.

5. Device (1) according to one of the previous patent claims, in which the first component carrier (3) and the second component carrier (4) form a contigous recess (11) for the positioning of strip conductors (12).

6. Device (1) according to one of the previous patent claims, in which the first component carrier (3) and the second component carrier (4) are made of plastic.

7. Device (1) according to one of the previous patent claims, in which the first component carrier (3) and the second component carrier (4) are of a selfsupporting design.

8. Device (1) according to one of the previous patent claims, in which only one component carrier has means of connection (13) to a control unit (14) for all components of the component carriers.

9. Motor vehicle (18) having at least one device (1) according to one of the previous patent claims.

## Revendications

1. Dispositif (1) destiné à une serrure (2) de véhicule à moteur comprenant au moins un premier support de composants (3) et un deuxième support de composants (4), les supports de composants fixant chacun au moins un composant du groupe comprenant un composant électrique (5), un composant électromécanique (6) et un composant électronique (7), par rapport à la serrure (2) du véhicule à moteur et étant reliés ou pouvant être reliés l'un à l'autre.

2. Dispositif (1) selon la revendication 1 **caractérisé en ce que** la surface de base (8) prévue du premier support de composants (3) est agrandie avec le deuxième support de composants (4).

3. Dispositif (1) selon la revendication 1 ou 2 **caractérisé en ce qu'**au moins le premier support de composants (3) ou le deuxième support de composants (4) est formé de façon plane et n'est relié qu'avec une partie de sa circonférence (9) à l'autre support de composants.

4. Dispositif (1) selon l'une des revendications précédentes **caractérisé en ce que** le premier support de composants (3) et le deuxième support de composants (4) forment une surface de pose commune (10), tout en s'y traversant partiellement.

5. Dispositif (1) selon l'une des revendications précédentes **caractérisé en ce que** le premier support de composants (3) et le deuxième support de composants (4) forment une cavité continue (11) pour le positionnement de réseaux de circuits imprimés (12).

6. Dispositif (1) selon l'une des revendications précédentes **caractérisé en ce que** le premier support de composants (3) et le deuxième support de composants (4) sont fabriqués en matière plastique.

7. Dispositif (1) selon l'une des revendications précédentes **caractérisé en ce que** le premier support de composants (3) et le deuxième support de composants (4) sont exécutés de façon autoportante.

8. Dispositif (1) selon l'une des revendications précédentes **caractérisé en ce que** seul un support de composants présente un élément de raccordement (13) à une unité de commande (14) pour tous les composants des supports de composants.

9. Véhicule à moteur (18) présentant au moins un dispositif (1) selon l'une des revendications précédentes.
